# EUROPEAN PATENT APPLICATION

(11) **EP 1 326 292 A1**
(43) Date of publication of application: **09.07.2003**
(21) Application number: 01958472.1
(22) Date of filing: 24.08.2001
(51) Int. Cl.: H01L 35/18

(54) **Bi GROUP THERMOELECTRIC CONVERSION MATERIAL AND THERMOELECTRIC CONVERSION ELEMENT**

(30) Priority: 24.08.2000 JP 2000253539
(71) Applicant: SUMITOMO SPECIAL METALS COMPANY LIMITED, Osaka-shi, Osaka 541-0041 (JP)
(72) Inventor: YAMASHITA, Osamu, Ibaraki-shi, Osaka 567-0046 (JP); KATAYAMA, Yasuhisa, Amagasaki-shi, Hyogo 660-0892 (JP); NAKAMURA, Yasuyuki, Takatsuki-shi, Osaka 569-0053 (JP); SAIGO, Tsunekazu, Matsubara-shi, Osaka 580-0033 (JP)
(74) Representative: Butler, Lance
(86) International application number: JP0107264
(87) International publication number: WO02017406

(57) **Abstract**

A thermoelectic conversion element enhanced in Seebeck coe field to a thermoelectric (electrotherinal) conversion material having a large Nernst effect. When a magnetic field is applied to a Bi group therinielectric conversion material having up to 5 at. % of specified added elements contained singly or in combination in Bi, a Seebeck coetticient increases substantially; and when a magnetic field is applied perpendicularly to a temperature gradient direction and a configuration is employed where electrodes are so arranged that a temperature gradient is given perpendicularl to both temperature gradient and magnetic.

## Description

### TECHNICAL FIELD

The present invention relates to a novel Bi-based thermoelectric conversion material suitable for thermoelectric conversion elements and Peltier elements and to a thermoelectric (electrothermal) conversion element wherein conversion efficiency is increased by employing a structure wherein the material is used, a magnetic field is applied thereto, and respective electrode materials are provided on the high-temperature side and low-temperature side where temperature gradient in the prescribed direction has been created.

### BACKGROUND ART

Thermoelectric conversion elements are devices that have been expected to find practical use for effective utilization of thermal energy which is in high demand in the present-day industrial world. The usage of such devices in a very wide field, for example, for systems for using waste heat and converting it into electric energy, small portable power generators for obtaining electricity outdoors in an easy manner, fire sensors of gas apparatuses, and the like, has been studied.

Thermoelectric conversion elements, for example, have a structure in which an element is obtained by employing powder metallurgy to bond directly thermoelectric conversion materials respectively demonstrating p-type conductivity and n-type conductivity, or by obtaining a pn junction of thermoelectric conversion materials respectively demonstrating p-type conductivity and n-type conductivity with a metal such as a silver braze or the like.

In addition to chalcogenide-type compounds such as IrSb₃, Bi₂Te₃, PbTe, and the like, which have high capacity, silicides such as FeSi₂, SiGe, and the like, which have a low thermoelectric characteristic, but are abundant as natural resources are known as thermoelectric conversion materials for forming the above-described elements.

In thermoelectric conversion elements, temperature gradient is provided between p-type and n-type thermoelectric conversion materials to convert heat into electricity. However, conversely, they are also well known to function as thermoelectric conversion elements that convert electricity into heat if a voltage is applied to the materials, that is, as Peltier elements.

In the conventional thermoelectric conversion elements, a thermoelectromotive force (cold-heat) has been generated by using a temperature gradient (electric potential difference) provided to materials, but the capacity index (ZT = S²/ρk, where S is a Seebeck coefficient, p is an electric resistivity, k is thermal conductivity) was, at most, close to 1 and could hardly be considered sufficient.

The conversion efficiency of thermoelectric conversion elements is very low, for example, by comparison with that (about 20%) of solar cells and does not exceed several percent, and is the main reason for the delayed practical use of thermoelectric conversion elements.

On the other hand, generation of electric field under magnetic field applied to a thermoelectric material having temperature gradient is known as a Nernst effect (L. D. Landau, E. M. Lifslitz, and L. P. Pitaevskli "Electrodynamics of Continuous Media", 2nd Edition, Pergamon Press, P. 101 (1984)).

However, in the field of conventional thermoelectric conversion elements, structures were suggested in which the efficiency of converting heat of a material into electricity was increased by applying a magnetic field, but the conversion efficiency was very low because of a low Seebeck coefficient of the thermoelectric conversion material.

### DISCLOSURE OF THE INVENTION

It is an object of the present invention to provide a thermoelectric conversion material with an optimum composition for employing a synergistic effect of the Seebeck effect and Nernst effect to increase a thermoelectromotive force of the material.

It is another object of the present invention to provide a thermoelectric conversion element in which the Seebeck coefficient is increased by applying a magnetic field to a thermoelectric conversion material with a strong Nernst effect, in view of the fact that improvement of material characteristics of the thermoelectric conversion material alone can result only in limited increase in thermoelectric conversion efficiency.

The inventors have conducted a comprehensive study of thermoelectric conversion materials capable of employing a synergistic effect of the Seebeck effect and Nernst effect and have discovered that the Seebeck effect can be increased substantially by applying a magnetic field to a Bi-based thermoelectric conversion material in which Bi contains no more than 5 at. % required additional elements added solely or in combination thereof.

Thus, the present invention provides a Bi-based thermoelectric conversion material in which Bi contains at least one of Group VI elements, rare earth elements, alkali metal elements, and alkaline earth metal elements, this thermoelectric conversion material demonstrating n-type conductivity, and a Bi-based thermoelectric conversion material in which Bi contains at least one of transition metal elements, Group III elements, and Group IV elements, this thermoelectric conversion material demonstrating p-type conductivity.

Further, the inventors have also conducted a comprehensive study of structures which allow the Seebeck coefficient to be increased by effectively applying a magnetic field to the above-described Bi-based thermoelectric conversion material and have discovered that the Seebeck coefficient is increased substantially by applying the magnetic field at a right angle to the direction of temperature gradient and employing a structure in which electrodes are arranged so that the difference in temperature is provided on the plane with a direction perpendicular to the directions of temperature gradient and magnetic field.

The inventors have also discovered that thermoelectric conversion efficiency is increased despite a comparatively small temperature gradient by using different electrode materials on a high-temperature side and low-temperature side provided with the difference in temperature. Those findings led to the creation of the present invention.

Thus, the present invention provides a thermoelectric conversion element comprising means for applying magnetic field H in the required direction (x axis direction) of a Bi-based thermoelectric conversion material demonstrating p-type and n-type conductivity, means for providing temperature gradient T in the direction (z axis direction) perpendicular to the aforesaid direction. and means for mounting respective electrode materials on the high-temperature side and low-temperature side of the temperature in the plane with a direction (y axis direction) perpendicular to the two aforesaid directions.

The present invention also provides a thermoelectric conversion element which uses a permanent magnet as means for applying magnetic field H, wherein the conversion efficiency can be greatly increased by using:
a structure in which different electrode materials are used on the low-temperature side and high-temperature side;
a structure in which the electrode material on the high-temperature side is one of Ag, Pt, Cu, Ti, In, Pb, Sn, Bi, and alloys thereof, and the electrode material on the low-temperature side is one of Cu, Pt, Al, Au, Fe, Mo, Zn, In, Pb, Sn, Bi, or alloys thereof, this material being different from that on the high-temperature side;
a structure in which permanent magnets and thermoelectric conversion materials are arranged alternately in the direction of magnetic field H application; and
a structure in which p-type and n-type thermoelectric conversion materials are arranged alternately on planes of sheet-like permanent magnets generating magnetic field in the thickness direction.

### BRIEF DESCRIPTION OF THE DRAWINGS

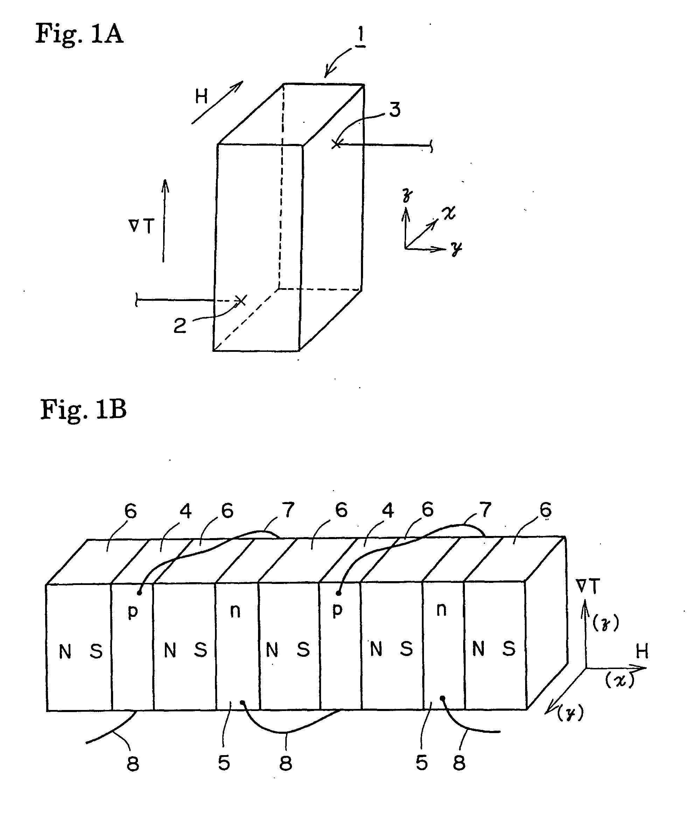

FIG. 1A is a perspective explanatory view of a thermoelectric conversion material illustrating a method for using the thermoelectric conversion material in accordance with the present invention; FIG. 1B is a perspective explanatory view illustrating an example of the structure of the thermoelectric conversion element in accordance with the present invention;

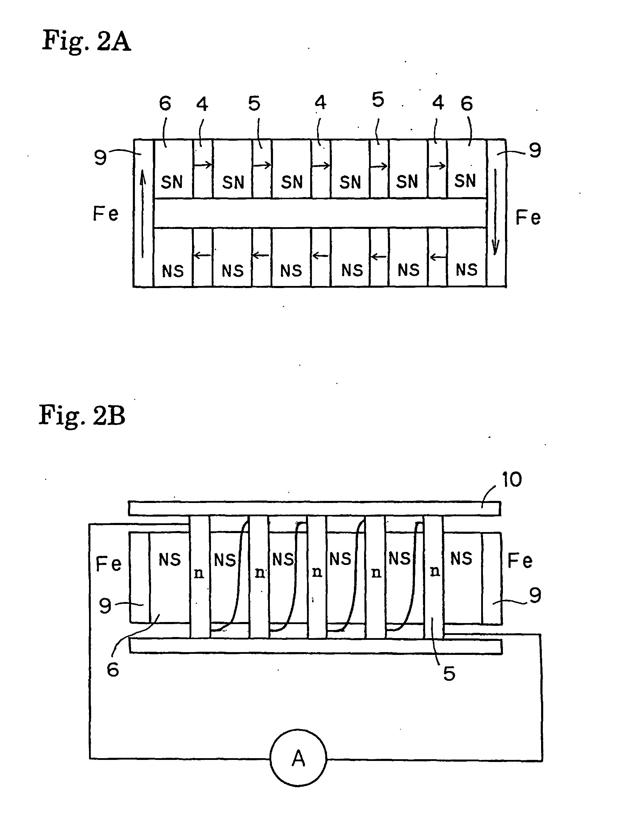

FIG. 2A is a perspective explanatory view illustrating another example of the structure of the thermoelectric conversion element in accordance with the present invention; FIG. 2B is a front explanatory view thereof; and

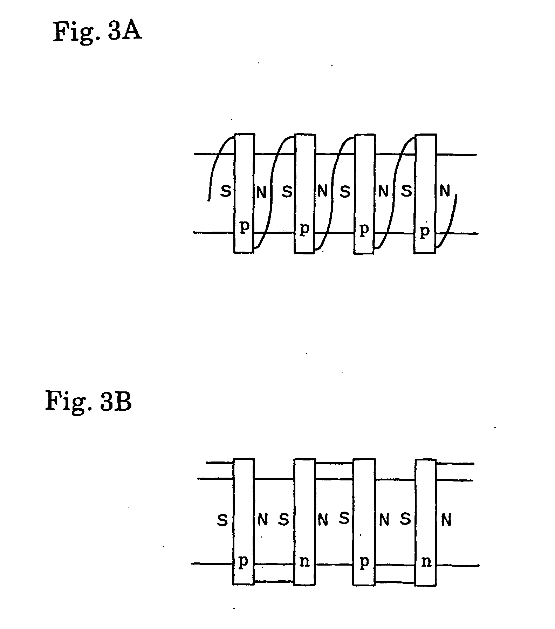

FIG. 3 is an explanatory view illustrating a connection state of lead wires of thermoelectric conversion elements in accordance with the present invention; A illustrates a structure consisting only of p-type or n-type materials, and B illustrates a structure in which p-type and n-type materials are used in pairs.

### BEST MODE FOR CARRYING OUT THE INVENTION

With the Bi-based thermoelectric conversion material in accordance with the present invention, carrier concentration can be changed by various additional elements and the Nernst effect can be augmented by the prescribed carrier concentration. Furthermore, the capacity index is also increased because electric resistivity is ten or more times less than that of the conventional Bi₂Te₃ system, Si-Ge system, and Fe-Si system.

Therefore, when the material in accordance with the present invention is used in a Peltier element in a magnetic field, it can become an electrothermal conversion material with a high cooling effect at a low electric current, and when it is used in a magnetic field as a thermoelectric conversion material, a high capacity index can be obtained and capacity can be increased.

With the Bi-based thermoelectric conversion material in accordance with the present invention, a material demonstrating n-type conductivity can be obtained by adding Group VI elements, rare earth elements, alkali metal elements, and alkaline earth metal elements to Bi, and a material demonstrating p-type conductivity can be obtained by adding transition metal elements, Group III elements and Group IV elements to Bi.
Among the additional elements, S, Se, Te are the preferred Group VI elements, La, Ce, Pr. Nd, Sm, Eu, Gd, Tb, Dy are the preferred rare earth elements, Li, Na, K are the preferred alkali metal elements, and Be, Ma, Ca, Sr, Ba are the preferred alkaline earth metal elements.

Among other additional elements, Ti, V, Cr, Mn, Fe, Co, Ni, Cu, Zn are the preferred transition metal elements, B, Al, Ge, In are the preferred Group III elements, and C, Si, Ce, Sn, Pb are the preferred Group IV elements.

The structure of the thermoelectric conversion element in accordance with the present invention will be explained below. Under the assumption that a Bi-based thermoelectric conversion material 1 in the shape of a rectangular parallelepiped shown in FIG. 1A is placed on a heat source, the temperature gradient ∇T will be provided in the z axis direction from the bottom upwards. Magnetic field H is applied in the x axis direction from the front of the figure backward. Furthermore, in order to create the difference in temperature between the two end surfaces of the Bi-based thermoelectric conversion material 1 in the y axis direction (left-right direction in the figure) which is perpendicular to the directions of temperature gradient ∇T and magnetic field H and also between the positive and negative electrodes, electrodes 2, 3 made of different materials are provided on the side with a high temperature T, which is the lower side on the left surface of Bi-based thermoelectric conversion material 1, as shown in the figure, and the side with a low temperature T, which is the upper side on the right surface, respective leads are connected to the electrodes, and thermoelectromotive force is led out therefrom.

In accordance with the present invention, magnetic field H is applied in the direction perpendicular to the direction of temperature gradient ∇T and electrodes are arranged so that a difference in temperature is provided in the plane in the direction perpendicular to the directions of temperature gradient ∇T and magnetic field H, that is, the difference in temperature is provided between the positive and negative electrodes. With such a structure, the Seebeck coefficient of Bi-based thermoelectric conversion element 1 is greatly increased even if the applied magnetic field H is low.

In accordance with the present invention, if the difference in temperature between electrodes 2, 3 is decreased, the generated electromotive force is due only to the Nernst effect produced by magnetic field H, and a large electromotive force cannot be obtained. Therefore, if the difference in temperature between electrodes 2, 3 is made no less than 1°C, the Seebeck coefficient is greatly increased by a synergistic effect of thermoelectric effect and Nernst effect. If this difference in temperature exceeds 5°C, the results are practically the same, even if a larger difference in temperature is provided. Furthermore, the preferred temperature is 50∼100°C, but sufficient magnetic field effect is demonstrated even at a temperature of several hundreds of degrees.

Basically, electrode - lead materials of any type or state can be used as the electrode materials. However, because the Bi-based thermoelectric conversion material in accordance with the present invention has a comparatively low melting point of about 600°C, it is preferred that a material with a low melting point be used as the electrode material. A variety of materials can be used for the leads connected to the electrodes, and no specific problem arises even when the electrodes and leads are of the same material, for example, as in the case of wire bonding.

Furthermore, using different electrode materials on the high-temperature side and low-temperature side makes it possible to increase thermoelectric conversion efficiency even if the temperature gradient is comparatively small.

It is preferred that one of Ag, Pt, Cu, Ti, In, Pb, Sn, Bi, or alloys thereof be used on the high-temperature side and one of Cu, Pt, Al, Au, Fe, Mo, Zn, In, Pb, Sn, Bi, or alloys thereof be used on the low-temperature side, this material being different from that on the low-temperature side. The term "alloys thereof" used hereinabove obviously covers the alloys of the metals within the above-listed groups, but also includes alloys of metals from those groups and other metals.

In accordance with the present invention, no specific limitation is placed on the strength of magnetic field H, but if it is no less than 1 kOe, the above-mentioned synergistic effect functions effectively. The preferred strength of magnetic field is no less than 3 k0e.

Any apparatus generating magnetic field, such as an electromagnetic coil, a superconductive magnet, and the like, and not only the permanent magnet, can be used as means for applying the magnetic field. Any magnetic field strength obtainable with a permanent magnet of any material and any shape, for example, in the shape of a block, plate, sheet, and the like, is sufficient.

For example, a magnetic field generated with a rare earth permanent magnet of a Sm-Co system or Ng-Fe-B system is extremely suitable in practical applications for thermoelectric conversion elements incorporating permanent magnets. In particular, when thermoelectric conversion is conducted at a high temperature of no less than 300°C, a permanent magnet of a Sm-Co system (Tc-900°C) with a high Curie point is preferably used as the magnet for magnetic field generation, and a permanent magnet of Nd-Fe-B system is preferably used at a temperature of less than 300°C.

When the Bi-based thermoelectric conversion materials and permanent magnets are arranged alternately, the above-described rare earth magnets demonstrate electric conductivity of metals. Therefore, it is preferred that the thermoelectric conversion materials and permanent magnets be electrically insulated from each other, that is, that they be insulated by coating an electrically insulating film on the surface of thermoelectric conversion materials or permanent magnets or both.

Conventional materials can be appropriately used for the electrically insulating film. It is especially preferred that a polyimide film or alumina film with good electric insulation properties be coated. The sufficient coating thickness is no more than several micrometers. Decreasing thickness of the film can make the gap between the magnets equal to the thickness of thermoelectric conversion material, thereby greatly suppressing the decrease in magnetic flux.

A polyimide film or alumina film is appropriately selected depending on the usage temperature. If the usage temperature is no higher than 700K, any of the two films can be used, and when the temperature is higher than 700K, the alumina film is appropriate. When the thermoelectric conversion material is coated on the portion which is to become an electrode, it is preferably masked in advance so as to prevent adhesion of the electrically insulating film.

In accordance with the present invention, means for providing temperature gradient is not specifically required to create a large difference in temperature, as described above. Therefore, any conventional method, for example heating or cooling one of thermoelectric conversion materials, or bringing into contact with a heating source or cooling source may be used and the appropriate method may be selected together with the below-described modularization of the thermoelectric conversion element.

Furthermore, because Bi-based thermoelectric materials have an electric resistivity of an order of 10⁻⁶ (Ωm), using as means for applying an electric potential difference for cooling or heating has an advantage of obtaining a large electric current even if the applied voltage is decreased, and modularization of Peltier elements with a high cooling-heating efficiency at a low difference in electric potential becomes possible.

Thermoelectric conversion elements of various structures can be assembled by using the p-type Bi-based thermoelectric conversion material and n-type Bi-based thermoelectric conversion material with the structure shown in FIG. 1A. Furthermore, in terms of modularizing the thermoelectric conversion elements with a magnetic field applied thereto, as shown in FIG. 1B, the advantage is that wires 7, 8 composed of p/n-joined different materials can be connected separately for a high-temperature side and low-temperature side by arranging the directions of magnetic fields H (x axis direction) of permanent magnets 6 in parallel and perpendicular to the direction (z axis direction) of temperature gradient ∇T and arranging the p-type Bi-based thermoelectric conversion materials 4 and n-type Bi-based thermoelectric conversion materials 5 alternately so as to sandwich the permanent magnets 6.

The structure of the closed magnetic circuit in the thermoelectric conversion element using the Bi-based thermoelectric conversion material will be explained below based on FIG. s 2A, B. The closed magnetic circuit is obtained by arranging in parallel the blocks of the same structure as shown in FIG. 1B in which a plurality of permanent magnets 6, p-type Bi-based thermoelectric conversion materials 4, and n-type Bi-based thermoelectric conversion materials 5 in the shape of a rectangular parallelepipeds and connecting the permanent magnets 6 on both ends of each block with sheets 9 of a magnetic material such as iron or the like.

For the Bi-based thermoelectric conversion materials used in a magnetic field, the rectangular parallelepiped shape shown in the figure or a rod-like shape is desired. Moreover, as shown in FIG. 2B, a design is required such that the Bi-based thermoelectric conversion materials 5 are longer than the permanent magnets 6 in the direction of temperature gradient and directly connected to a cooling-heating plate or heating plate 10, so that heat is not conducted through the permanent magnets 6.

Employing such an arrangement allows the difference in temperature (difference in electric potential) to be automatically provided between the electrodes of Bi-based thermoelectric conversion materials 5.

As for the direction of wires, when a thermoelectric conversion element is composed of p-type and n-type pairs and the structure is, for example, such that a p-type thermoelectric conversion material 4 is located on the left end, as shown by directions along three axis in FIG. 1B, wires 8 on the low-temperature side (low-potential side) are connected to the lower side of the back end surface shown in the figure, wires 7 on the high-temperature side (high-potential side) are connected to the upper side of the front end surface, and other ends thereof are connected to the same potential side of n-type thermoelectric conversion materials 5 adjacent thereto via permanent magnets 6. In the structure shown in FIG. 2B, only n-type Bi thermoelectric conversion materials are used and wiring is made alternately from the high-temperature side to the low-temperature side. The wiring similar to that shown in FIG. 2B is also made when only p-type thermoelectric conversion materials are used.

In short, when the structure is composed only of p-type or n-type materials, alternate wiring shown in FIG. 3A is used, and when p-type and n-type pairs are used, p-type and n-type low-temperature sides and high-temperature sides may be wired together, as shown in FIG. 3B.

### Examples

### Example 1

In order to fabricate n-type and p-type Bi-based thermoelectric conversion materials, elements shown in Table 1 were mixed with high-purity Bi (4N) in the predetermined ratios and the mixture was vacuum sealed in a quartz tube and high-frequency melted. The obtained ingot in the form of a circular rod was machined to obtain a 10 × 10 × 1 mm shape and a Hall coefficient was measured to verify the polarity and carrier concentration. The results are shown in Table 2.

The ingot was then cut to the size and shape shown in FIG. 3, Seebeck coefficient and Seebeck current were measured, and output power was calculated. As for the Seebeck coefficient and Seebeck current of the sample, the voltage of In-soldered copper wire on both ends of the thermoelectric material was measured by changing the magnetic field applied to the thermoelectric material at a constant average temperature of the high-temperature side and low-temperature side of 50°C and a constant difference in temperature of 5°C.

The strength of magnetic field was adjusted by changing the spacing between the Nd-Fe-B permanent magnets. Furthermore, the power generated at this time was determined by measuring the voltage (µV/K) and current value (µA/K) per unit temperature. The measurement results are shown in Table 3.

**Table 1**

| No. | Composition (at%) Bi | Added elements | Amount added (at%) | Polarity |
|---|---|---|---|---|
| A | 100 | - | 0. | n |
| B | 100 | Ga | 0. | n |
| C | 100 | Ga | 5. | p |
| D | 100 | In | 11. | n |
| E | 100 | S | 1. | n |

**Table 2**

| No. | Carrier concentration (l/m³) | Electric resistivity (Ωm) | Polarity |
|---|---|---|---|
| A | 3.0×10²⁵ | 1.2×10⁻⁶ | n |
| B | 7.8×10²⁴ | 2.2×10⁻⁶ | n |
| C | 3.4×10²⁴ | 4.6×10⁻⁶ | p |
| D | 3.8×10²³ | 4.3×10⁻⁶ | n |
| E | 4.8×10²⁵ | 8.7×10⁻⁷ | n |

**Table 3**

| No. | Sam ple | Sample dimensions a×b×c (mm) | Magnet ic field (T) | Seebeck coefficie nt (µV/K) | Seebeck current (µA/K) | Output power (10⁻⁹W/K²) | Power ratio |
|---|---|---|---|---|---|---|---|
| 1 | A | 5×5×10 | 1.0 | 120 | 1.2 | 0.144 | 2.25 |
| 2 | A | 5×5×10 | 0 | 80 | 0.8 | 0.064 | 1 |
| 3 | A | 5×5×10 | 0.1 | 90 | 0.9 | 0.081 | 1.27 |
| 4 | B | 5×5×10 | 1.0 | 120 | 1.2 | 0.144 | 2.25 |
| 5 | C | 5×5×10 | 1.0 | 170 | 1.7 | 0.289 | 4.52 |
| 6 | D | 5×5×10 | 1.0 | 60 | 1.6 | 0.036 | 0.56 |
| 7 | E | 5×5×10 | 1.0 | 180 | 1.8 | 0.324 | 5.06 |

### Example 2

In order to study the Peltier effect, electric current 1A was passed in the direction of dimension b of the sample of Example 1 and the temperature on the upper surface (decreasing temperature) in the b axis direction after 10 seconds was measured. The results are shown in Table 4.

**Table 4**

| No. | Sample | Sample dimensions a×b×c (mm) | Magnetic field (T) | Decreasing temperature (after 10 seconds) (K) |
|---|---|---|---|---|
| 1 | A | 5×5×10 | 1.0 | 1.2 |
| 2 | A | 5×5×10 | 0 | 0.8 |
| 3 | A | 5×5×10 | 0.1 | 0.9 |
| 4 | B | 5×5×10 | 1.0 | 1.2 |
| 5 | C | 5×5×10 | 1.0 | 1.7 |
| 6 | D | 5×5×10 | 1.0 | 1.6 |
| 7 | E | 5×5×10 | 1.0 | 1.8 |

### Example 3

Copper wires and electrodes that have different compositions on the low-temperature side and high-temperature side which are shown in Table 5 were mounted on samples No. 1, 4, 7 cut to the dimensions and shape shown in Table 3 in Example 1. Then, Seebeck coefficient and Seebeck current were measured under the following conditions: average temperature 50°C, temperature difference 5°C, magnetic field strength 1.0 T. Measurements of electric power were conducted in the same manner as in Example 1. The measurement results are shown in Table 5.

In order to study the Peltier effect, electric current 1A was passed in the direction of dimension b of the sample and the temperature on the upper surface (decreasing temperature) in the b axis direction after 10 seconds was measured. The results are shown in Table 5.

**Table 5**

| No. | Sa mp le | Electrode material | | Seebeck coefficient (µV/K) | Seebeck current (µA/K) | Output power (10⁻⁹W/K²) | Decreasing temperature (after 10 seconds) (K) |
|---|---|---|---|---|---|---|---|
| | | High-temp erature side | Low-tempe rature side | | | | |
| 1 | A | In | 37Pb-63Sn | 134 | 1.34 | 0.180 | 1.4 |
| 4 | B | 58Bi-42Sn | 37Pb-63Sn | 143 | 1.43 | 0.204 | 1.5 |
| 7 | E | 58Bi-42Sn | In | 194 | 1.94 | 0.376 | 2.2 |

### INDUSTRIAL APPLICABILITY

In the thermoelectric conversion element in accordance with the present invention, characteristics of a Bi-based thermoelectric conversion material can be greatly improved in an easy manner by applying a magnetic field to the thermoelectric conversion material, applying a temperature gradient in the required direction, creating a difference in temperature between the electrodes and using the synergistic effect of the Seebeck effect and Nernst effect.

Furthermore, selecting different materials for the electrodes of the thermoelectric element on the high-temperature side and low-temperature side makes it possible to increase substantially a thermoelectric conversion efficiency by comparison with that obtained when metal electrodes of the same kind were used, even when the temperature gradient is comparatively small.

In accordance with the present invention, when a thermoelectric conversion element is constructed, a structure is employed in which magnetic field is generated by permanent magnets. Therefore, the advantage of the present invention is that a thermoelectric conversion element of a comparatively simple structure can be easily fabricated and maintenance-free used.

## Claims

1. A Bi-based thermoelectric conversion material wherein Bi contains no more than 5 at.% added element (s) solely or in combination.

2. The Bi-based thermoelectric conversion material according to claim 1, wherein Bi contains at least one of Group VI elements, rare earth elements, alkali metal elements, and alkaline earth metal elements, this thermoelectric conversion material demonstrating n-type conductivity.

3. The Bi-based thermoelectric conversion material according to claim 1, wherein Bi contains at least one of transition metal elements, Group III elements and Group IV elements, this thermoelectric conversion material demonstrating p-type conductivity.

4. A thermoelectric conversion element comprising means for applying magnetic field H in the required direction (x axis direction) of a Bi-based thermoelectric conversion material containing no more than 5 at.% added element (s) solely or in combination, means for providing temperature gradient ∇T in the direction (z axis direction) perpendicular to the aforesaid direction, and means for mounting and connecting respective electrode materials onto a high-temperature side and low-temperature side of the plane in the direction (y axis direction) perpendicular to said two directions and also leading out the thermoelectromotive force from the connected terminals.

5. The thermoelectric conversion element according to claim 4, wherein electrode materials on the low-temperature side and high-temperature side are different materials.

6. The thermoelectric conversion element according to claim 5, wherein the electrode material on the high-temperature side is one of Ag, Pt, Cu, Ti, In, Pb, Sn, Bi, and alloys thereof, and the electrode material on the low-temperature side is one of Cu, Pt, Al, Au, Fe, Mo, Zn, In, Pb, Sn, Bi, or alloys thereof, this material being different from that on the high-temperature side.

7. The thermoelectric conversion element according to claim 4, wherein the strength of magnetic field H is no less than 1 k0e.

8. The thermoelectric conversion element according to claim 4, wherein means for applying magnetic field H has a closed magnetic circuit structure created of permanent magnets wherein permanent magnets and thermoelectric conversion materials are arranged alternately in the direction of applying magnetic field H.

9. The thermoelectric conversion element according to claim 8, wherein the surfaces of thermoelectric conversion materials or permanent magnets or both are insulated by coating an electrically insulating films thereon.

10. The thermoelectric conversion element according to claim 9, wherein the electrically insulating film is polyamide or Al₂O₃.
